Europäisches Patentamt

European Patent Office

Office européen des brevets

(11) Veröffentlichungsnummer: **0 359 967**
**A2**

# (12) EUROPÄISCHE PATENTANMELDUNG

(21) Anmeldenummer: **89114584.9**

(51) Int. Cl.⁵: **H01S 3/085 , G02F 1/225**

(22) Anmeldetag: **07.08.89**

(30) Priorität: **20.09.88 DE 3831943**

(43) Veröffentlichungstag der Anmeldung:
**28.03.90 Patentblatt 90/13**

(84) Benannte Vertragsstaaten:
**DE FR GB IT NL**

(71) Anmelder: **Siemens Aktiengesellschaft**
**Wittelsbacherplatz 2**
**D-8000 München 2(DE)**

(72) Erfinder: **Auracher, Franz, Dr.**
**Eichenstrasse 26**
**D-8021 Baierbrunn(DE)**
Erfinder: **Meissner, Eckhard, Dipl.-Ing.**
**Bölgstrasse 2**
**D-8000 München 83(DE)**
Erfinder: **Noll, Bernd, Dipl.-Ing.**
**Zillertalstrasse 69**
**D-8000 München 70(DE)**
Erfinder: **Wittmann, Julius, Dipl.-Ing.**
**Ibnerer Stockweg 7**
**D-8024 Oberhaching(DE)**

(54) **Externer optischer Resonator für einen Halbleiterlaser.**

(57) Es soll ein externer optischer Resonator für einen Halbleiterlaser mit einem optischen Richtkoppler angegeben werden, der in integrierter Technik in so kurzer Baulänge ausführbar ist, daß ein freier Spektralbereich im 100 GHz-Bereich ermöglicht ist, wobei zudem der Resonator und eine Systemfaser an dieselbe Endfläche des Lasers ankoppelbar sind.

Dazu wird eine Resonatorstruktur verwendet, bei welcher an einem Wellenleiter des optischen Richtkopplers, in den die vom Halbleiterlaser abgestrahlte Lichtleistung eingekoppelt wird, keine, an beiden Endflächen des anderen Wellenleiters des Richtkopplers dagegen jeweils eine Rückkopplungsanordnung angeordnet ist. Eine Systemfaser ist an den einen Wellenleiter ankoppelbar.

Anwendung für abstimmbare Halbleiterlaser, insbesondere für den Überlagerungsempfang

FIG 1

### Externer optischer Resonator für einen Halbleiterlaser

Die Erfindung betrifft einen externen optischen Resonator für einen Halbleiterlaser nach dem Patentanspruch 1.

Für die Realisierung kohärent optischer Übertragungssysteme werden einmodige, schmalbandige Lasersender benötigt. Fabry-Perot-Halbleiterlaser haben ein mehrmodiges Spektrum. In Verbindung mit externen Resonatoren können aus solchen Halbleiterlasern schmalbandige, einmodige Lasersender realisiert werden (siehe dazu Brit. Telecom. Techn. Journ., Vol. 3, No. 4, 1985), die für optische Nachrichtensysteme mit Heterodyn- oder Homodynempfang geeignet sind.

Aus der E-A2-O 216 212 ist ein solcher externer otpischer Resonator bekannt, der aus einem zwei optische Wellenleiter aufweisenden optischen Richtkoppler besteht, wobei durch eine Endfläche eines der beiden Wellenleiter eine vom Halbleiterlaser abgestrahlte Lichtleistung in den Richtkoppler einkoppelbar ist. An der anderen Endfläche dieses einen Wellenleiters ist eine Rückkopplungseinrichtung vorgesehen, die einen geringen Teil einer in diesem einen Wellenleiter zugeführten Lichtleistung in diesen einen Wellenleiter rückkoppelt, den größeren Teil dieser Lichtleistung aber aus diesem einen Wellenleiter auskoppelt.

Die ausgekoppelte Lichtleistung wird durch eine Faser einer Endfläche des anderen Wellenleiters des Richtkopplers zugeführt und in diesen anderen Wellenleiter eingekoppelt. Eine aus der anderen Endfläche des anderen Wellenleiters ausgekoppelte Lichtleistung wird entweder einem Strahlungsabsorber zugeführt oder als eine Ausgangsleistung des Halbleiterlasers in eine Systemfaser eingekoppelt. Bei der letztgenannten Ausführungsform sind Systemfaser und Resonator an dieselbe Endfläche des Lasers angekoppelt. Dies hat gegenüber der Ausführungsform, bei welcher Resonator und Systemfaser an verschiedene Endflächen des Lasers angekoppelt sind, den Vorteil, daß der mechanische Aufwand erniedrigt ist.

Der optische Richtkoppler kann aus einem Glasfaserrichtkoppler oder aus einem integrierten Richtkoppler bestehen.

An dem einen Tor des anderen Wellenleiters des Richtkopplers kann eine zweite Rückkopplungseinrichtung angeordnet sein, die einen geringen Teil der in der Faser zugeführten Lichtleistung in die Faser rückkoppelt.

Ein externer optischer Resonator in Form eines zwei optische Wellenleiter aufweisenden faseroptischen Richtkopplers, bei dem es möglich ist, den Resonator und eine Systemfaser an dieselbe Endfläche des Halbleiterlasers anzukoppeln, ist in der älteren deutschen Patentanmeldung P 36 33 077.9 (VPA 86 P 1678 DE) vorgeschlagen. Dieser frequenzselektive Faserrichtkoppler besteht aus einer dispersiven Doppelkernfaser, wobei die beiden Kerne die beiden optischen Wellenleiter des Richtkopplers bilden. Eine Endfläche eines Kerns ist an den Halbleiterlaser angekoppelt und die auf der gleichen Seite wie diese Endfläche angeordnete Endfläche des anderen Kerns ist frei. An den anderen Endflächen beider Kerne ist eine Rückkopplungseinrichtung angeordnet, die einen geringen Teil einer in dem einen Kern zugeführten Lichtleistung in diesen Kern rückkoppelt, den anderen Teil aus diesem Kern auskoppelt. In Bezug auf den anderen Kern hat die Rückkopplungseinrichtung keine Funktion. Die aus dem einen Kern ausgekoppelte Lichtleistung ist in eine Systemfaser eingekoppelt.

In der älteren deutschen Patentanmeldung P 36 33 076.0 (VPA 86 P 1677 DE) sind externe Resonatoren für Halbleiterlaser vorgeschlagen, die mit integriert optischen Richtkopplern aufgebaut sind und bei denen die Systemfaser und der Resonator an dieselbe Endfläche des Halbleiterlasers angekoppelt sind. Die beiden optischen Wellenleiter des Richtkopplers sind auf einem Substrat integrierte Streifenwellenleiter. Die vom Halbleiter laser abgestrahlte Lichtleistung wird in einen Streifenwellenleiter eingekoppelt und an der anderen Endfläche dieses Wellenleiters ist eine Rückkopplungseinrichtung vorgesehen, welche die aus diesem einen Wellenleiter zugeführte Lichtleistung in diesen Wellenleiter rückkoppelt. An einer Endfläche des anderen Streifenwellenleiters, die auf der gleichen Seite wie die andere Endfläche des einen Wellenleiters angeordnet ist, ist eine Rückkopplungseinrichtung vorgesehen, die eine in diesem anderen Wellenleiter zugeführte Lichtleistung in diesen Wellenleiter rückkoppelt. An eine andere Endfläche dieses anderen Wellenleiters ist die Systemfaser angekoppelt. Zur Erzielung eines einmodigen Betriebs ist es wichtig, daß die beiden Rückkopplungseinrichtungen in verschiedenen optischen Abständen von einer Koppelstrecke des Richtkopplers angeordnet sind. Die Koppelstrecke eines Richtkopplers ist durch die Strecke definiert, in denen seine beiden Wellenleiter in einem so geringen Abstand nebeneinander geführt sind, daß eine Leistungsüberkopplung zwischen den Wellenleitern auftritt.

Aufgabe der Erfindung ist es, einen mit geringem Justieraufwand herstellbaren externen optischen Resonator für einen Halbleiterlaser mit einem zwei Wellenleiter aufweisenden optischen Richtkoppler anzugeben, der in integrierter Technik in so kurzer Baulänge ausführbar ist, daß ein freier Spektralbereich im 100 GHz-Bereich ermöglicht ist, wobei zudem der Resonator und eine Systemfaser an dieselbe Endfläche des Lasers ankoppelbar sind.

Diese Aufgabe wird durch die im Patentanspruch 1 angegebenen Merkmale gelöst.

Der wesentliche Unterschied des erfindungsgemäßen Resonators im Vergleich zu dem bekannten Resonator oder den vorgeschlagenen Resonatoren besteht darin, daß an dem einen Wellenleiter des optischen Richtkopplers, in den die vom Halbleiterlaser abgestrahlte Lichtleistung eingekoppelt wird, keine, an beiden Endflächen des anderen Wellenleiters dagegen eine Rückkopplungseinrichtung angeordnet ist.

Bevorzugterweise besteht bei einem erfindungsgemäßen Resonator gemäß Anspruch 2 der Richtkoppler aus einem integriert optischen Richtkoppler. Jedoch können auch andere Richtkoppler, beispielsweise Faserrichtkoppler, verwendet werden, insbesondere dann, wenn es nicht auf eine kurze Kanallänge ankommt.

Sieht man bei dem erfindungsgemäßen Richtkoppler die Maßnahme gemäß Anspruch 3 vor, nach welcher eine Brechzahl wenigstens eines Wellenleiters des Richtkopplers innerhalb einer Koppelstrecke dieses Kopplers veränderbar ist, so kann die Resonanzfrequenz und die Phase des Resonators abgestimmt werden.

Ein erfindungsgemäßer Resonator kann vorteilhafterweise in kurzen Baulängen von einigen Millimetern realisiert werden. Wegen dieser kurzen Baulänge kann ein freier Spektralbereich FSR und somit ein Abstimmbereich des mit diesem Resonator realisierten Lasersenders von einigen 100 GHz realisiert werden, was für eine optische Vielkanalübertragung erforderlich ist.

Die Maßnahme nach Anspruch 3 läßt sich auf einfache Weise durch die im Anspruch 4 angegebenen Merkmale realisieren, wodurch ein externer integriert optischer Resonator geschaffen ist, der elektrisch abstimmbar ist.

Es sei in diesem Zusammenhang darauf hingewiesen, daß bereits in der obengenannten älteren deutschen Patentanmeldung P 36 33 076.0 (VPA 86 P 1677 DE) ein integriert optischer externer Resonator mit einem zwei Wellenleiter aufweisenden Richtkoppler vorgeschlagen ist, bei dem ein Wellenleiter aus elektrooptischem Material besteht und bei dem eine Einrichtung zum Erzeugen eines veränderbaren elektrischen Feldes im elektrooptischen Material vorgesehen ist. Diese Einrichtung ist dort ein Phasenmodulator, der zur Erzeugung eines frequenzmodulierten Ausgangssignals dient.

Die Maßnahme nach Anspruch 3 läßt sich auf einfache Weise durch die im Anspruch 5 angegebenen Merkmale realisieren, wodurch ein thermisch oder mechanisch abstimmbarer Resonator geschaffen ist.

Ein abstimmbarer Resonator wird auch erhalten, wenn gemäß Anspruch 6 eine Länge wenigstens eines der beiden Wellenleiter des Richtkopplers veränderbar ist. Dies läßt sich ebenfalls durch Andern der Temperatur des Wellenleiters oder Ausüben eines Druckes oder Zuges auf diesen erreichen.

Die Rückkopplungseinrichtung selbst kann bei einem erfindungsgemäßen Resonator gemäß Anspruch 7 aus einer aus einem Trägerkörper aufgebrachten Spiegelschicht bestehen.

Die Erfindung wird anhand der Figuren in der folgenden Beschreibung näher erläutert. Von den Figuren zeigen:

Figur 1 eine nicht maßstabsgetreue schematische Darstellung eines Lasersenders mit einem erfindungsgemäßen Resonator, an den eine Systemfaser angekoppelt ist, und

Figur 2 einen Schnitt durch den optischen Richtkoppler längs der Schnittlinie II - II in Figur 1, wobei Elektroden zum Anlegen von Steuerspannungen zur Veränderung der Brechzahl der Wellenleiter vorgesehen sind.

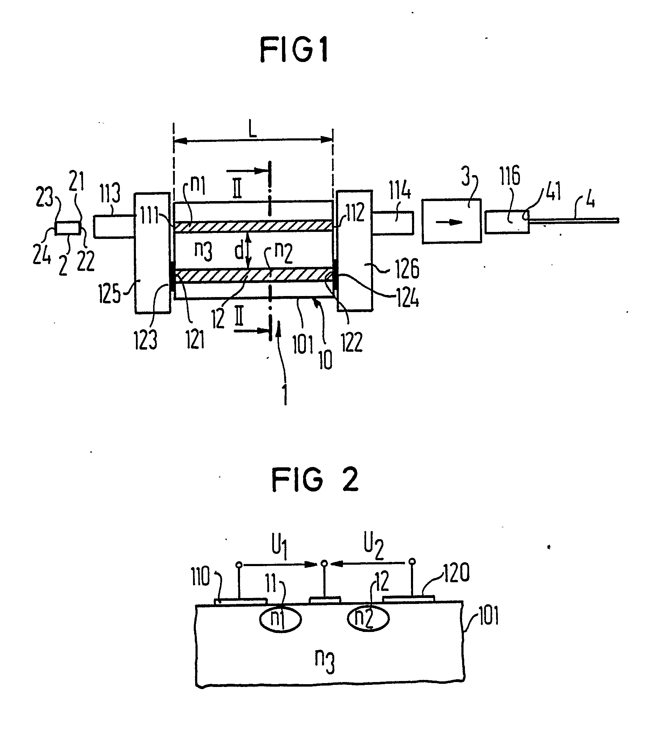

Der Lasersender nach Figur 1 besteht im wesentlichen aus dem externen optischen Resonator 1 und dem Halbleiterlaser 2. Die dem Resonator 1 zugekehrte Endfläche 21 des Lasers 2, der dessen Ausgangsleistung entnehmbar ist, ist beispielsweise mit einer Antireflexschicht 22 entspiegelt. Die vom Resonator abgekehrte Endfläche 23 des Halbleiterlasers 2 ist zur Erhöhung seiner Ausgangsleistung mit einer Spiegelschicht 24 verspiegelt.

Der Resonator 1 besteht im wesentlichen aus dem optischen Richtkoppler 10 und den beiden Rückkopplungseinrichtungen 123 und 124.

Der optische Richtkoppler 10 besteht aus zwei auf einem Substrat aus beispielsweise elektrooptischem Material, z.B. Lithiumniobat, integrierten Streifenwellenleitern 11 und 12, die längs einer Koppelstrecke L in einem so geringen Abstand d nebeneinander geführt sind, daß zwischen ihnen eine Leistungsüberkopplung auftritt. Die Brechzahlen $n_1$ und $n_2$ der beiden Wellenleiter 11 bzw. 12 sind höher als die Brechzahl $n_3$ des Substratmaterials. Die Brechzahlen $n_1$ und $n_2$ können gleich sein.

Im dargestellten Ausführungsbeispiel ist die Koppelstrecke L gleich der Baulänge des Richtkopplers gewählt, die im wesentlichen der Baulänge des Resonators entspricht.

Die vom Halbleiterlaser 2 aus der Endfläche 21 abgestrahlte Lichtleistung wird von einer Gradientenlinse 113 durch ein Glasplättchen 125 hindurch auf eine Endfläche 111 des einen Wellenleiters 11 fokussiert und in diesen einen Wellenleiter eingekoppelt. Aus der anderen Endfläche 112 des einen Wellenleiters 11 koppelt eingekoppelte Lichtleistung aus, durchstrahlt ein Glasplättchen 126 und wird von einer anderen Gradientenlinse 114 gebündelt. Die gebündelte Lichtleistung wird von einer weiteren Gradientenlinse 116 auf eine Endfläche 41 einer Systemfaser 4 fokussiert und in diese als Ausgangsleistung des Lasers 2 eingekoppelt. Im Strahlengang der aus dem einen Wellenleiter 11 ausgekoppelten Lichtleistung ist vor der Systemfaser, beispielsweise zwischen der Gradientenlinse 114 und der weiteren Gradientenlinse 116 ein optischer Isolator 3 angeordnet, der parasitäre Reflexe aus dem System unterdrückt, die sonst zum Halbleiterlaser 2 gelangen könnten.

Die Glasplättchen 125 und 126 dienen jeweils als Trägerkörper für eine Rückkopplungseinrichtung 123 bzw. 124, die beispielsweise in Form einer lokalen Metallisierung, beispielsweise Vergoldung, der Glasplättchen 125 und 126 bestehen können.

In Figur 1 bedeutet $n_1$ die Brechzahl des einen Wellenleiters 11, $n_2$ die Brechzahl des anderen Wellenleiters 12 und $n_3$ die Brechzahl des Substrats 101, die kleiner als $n_1$ und kleiner als $n_2$ sein muß.

Für den Fall, daß $n_1 = n_2 = n$ ist, treten bei dem Resonator nach Figur 1 Resonanzen bei $\beta . L = m . \pi$ mit einem freien Spektralbereich von FSR $= c/2n . L$ auf, wobei $\beta$ die Ausbreitungskonstante einer in den Wellenleitern 11 und 12 geführten optischen Welle und m eine beliebige ganze Zahl bedeuten. Die Finesse des Resonators nach Figur 1 beträgt $F = \pi \Gamma R.\cos^2 kL/(1-R\cos^2 kL)$, wobei R den Leistungsreflexionsfaktor der Rückkopplungseinrichtung 123 und 124 und k eine Zahl bedeuten.

Durch Veränderung der Brechzahl $n_2$ kann die Resonanzfrequenz des Resonators nach Figur 1 abgestimmt werden. Die Phase des reflektierten Lichts ist über $n_1$ abstimmbar.

Wie die Brechzahlen der Wellenleiter 11 und 12 verändert werden können, ist bereits angegeben worden. In der Figur 2 ist ein Beispiel angegeben, bei dem der Resonator nach Figur 1 elektrisch abstimmbar ist.

Beim Beispiel nach Figur 2 besteht das Substrat 101 aus Lithiumniobat. Die Wellenleiter 11 und 12 sind in dieses Substrat eindiffundiert. Es sei angenommen, dßa $n_1 = n_2 = n$ gilt. Zwischen den beiden Wellenleitern 11 und 12 verläuft in deren Längsrichtung eine auf das Substrat aufgebrachte oder über dem Substrat angeordnete Elektrode 100. Auf den Außenseiten der beiden Wellenleiter 11 und 12 verlaufen ebenfalls in deren Längsrichtung zwei Elektroden 110 und 120, die ebenfalls auf das Substrat 101 aufgebracht oder über diesem angeordnet sind.

Zur Abstimmung der Resonanzfrequenz des Resonators nach Figur 2 wird zwischen der Elektrode 100 und der Elektrode 120 eine elektrische Spannung $U_2$ angelegt, die im anderen Wellenleiter 12 ein quer zu dessen Längsrichtung verlaufendes elektrisches Feld erzeugt und die Brechzahl n verändert.

Ähnlich wird zwischen den Elektroden 110 und 100 eine elektrische Spannung $U_1$ angelegt, die im einen Wellenleiter 11 ein quer zu dessen Längsrichtung verlaufendes elektrisches Feld erzeugt, das die Brechzahl n dieses einen Wellenleiters 11 verändert. Durch Einstellen der Spannungen $U_1$ und $U_2$ kann der Lasersender innerhalb des freien Spektralbereichs FSR abgestimmt werden. Für das Durchstimmen um einen freien Spektralbereich FSR ist ein Spannungslängenprodukt von 90 Volt . mm bei einer Wellenlänge von 1,3 $\mu$m ausreichend. Bei einer Resonatorlänge von z.B. einem Millimeter liegen somit die erforderlichen Spannungen $U_1$ und $U_2$ im Bereich von $\pm$ 45 Volt.

## Ansprüche

1. Externer Resonator (1) für einen Halbleiterlaser (2), bestehend aus einem zwei optische Wellenleiter (11, 12) aufweisenden optischen Richtkoppler (10),
wobei durch eine Endfläche (101) eines (11) der beiden Wellenleiter (11, 12) eine vom Halbleiterlaser (2) abgestrahlte Lichtleistung in den Richtkoppler (10) einkoppelbar und aus einer anderen Endfläche (112) dieses einen Wellenleiters (11) entnehmbar ist und
wobei an jeder Endfläche (121, 122) des anderen Wellenleiters (12) eine optische Rückkopplungseinrichtung (123, 124) angeordnet ist, die eine aus dem anderen Wellenleiter (12) zugeführte Lichtleistung zumindest teilweise in diesen anderen Wellenleiter (12) rückkoppelt.

2. Resonator nach Anspruch 1, **dadurch gekennzeichnet,** daß der Richtkoppler (10) aus einem integriert optischen Richtkoppler besteht.

3. Resonator nach Anspruch 1 oder 2, **dadurch gekennzeichnet,** daß eine Brechzahl ($n_1$, $n_2$) wenigstens eines Wellenleiters (11, 12) des Richtkopplers (10) veränderbar ist.

4. Resonator nach Anspruch 3, **dadurch gekennzeichnet,** daß der Wellenleiter (11, 12) mit veränderbarer Brechzahl ($n_1$, $n_2$) aus elektro- oder magnetooptischem Material besteht, und daß eine Einrichtung (100, 110, 120) zum Erzeugen eines veränderbaren elektrischen bzw. magnetischen Feldes im elektro- bzw. magnetoopischen Material vorgesehen ist.

5. Resonator nach Anspruch 3 oder 4, **dadurch gekennzeichnet,** daß der Wellenleiter (11, 12) mit veränderbarer Brechzahl ($n_1$, $n_2$) aus thermo- oder elastooptischem Material besteht, und daß eine Einrichtung zum Verändern der Temperatur des thermooptischen Materials oder Ausüben eines Druckes oder Zuges auf das elastooptische Material vorgesehen ist.

6. Resonator nach einem der vorhergehenden Ansprüche, **dadurch gekennzeichnet,** daß die Länge (L) wenigstens eines der beiden Wellenleiter (11, 12) des Richtkopplers (10) veränderbar ist.

7. Resonator nach einem der vorhergehenden Ansprüche, **dadurch gekennzeichnet,** daß eine Rückkopplungseinrichtung (123, 124) aus einer auf einem Trägerkörper (125, 126) aufgebrachten Spiegelschicht besteht, die gegenüber der betreffenden Endfläche (121 bzw. 122) des anderen Wellenleiters (12) angeordnet ist.

# FIG 1

# FIG 2